(19) Europäisches Patentamt
European Patent Office
Office européen des brevets

(11) **EP 4 597 147 A1**

(12) **EUROPEAN PATENT APPLICATION**

(43) Date of publication:
**06.08.2025 Bulletin 2025/32**

(21) Application number: **24155291.8**

(22) Date of filing: **01.02.2024**

(51) International Patent Classification (IPC):
***G01R 33/56*** (2006.01)

(52) Cooperative Patent Classification (CPC):
**G01R 33/5607; G01R 33/5605**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Koninklijke Philips N.V.
5656 AG Eindhoven (NL)**

(72) Inventors:
• **EGGERS, Holger
  Eindhoven (NL)**
• **KEUPP, Jochen
  Eindhoven (NL)**

(74) Representative: **Philips Intellectual Property &
Standards
High Tech Campus 52
5656 AG Eindhoven (NL)**

(54) **CEST IMAGING WITH VARIABLE FLIP ANGLE**

(57)     Disclosed herein is an MRI system (100) configured for acquiring MRI data (414) and a method of processing the MRI data. The MRI system (100) comprises a processor (402) configured to control the MRI system (100) with pulse sequence commands (412) to acquire the MRI data (414) for a plurality of saturation frequencies (416). For a partial inversion pulse of the SPIR a varying flip angle is used, which is varied depending on the saturation frequencies (416) being used.

Fig. 1

**Description**

TECHNICAL FIELD

The invention relates to magnetic resonance imaging systems and methods.

BACKGROUND

Magnetic resonance imaging (MRI) systems rely on a large static magnetic field (Bo) to align the nuclear spins of atoms as part of a procedure for producing images within a subject. These images may reflect various quantities or properties of the subject. For example, the density of hydrogen protons may be measured and resolved spatially. However, often a compound or metabolite is so dilute that as a practical matter it is not possible to image it directly.

Therefore, techniques such as chemical exchange saturation transfer (CEST) MRI have been developed. In CEST imaging, the presence of dilute metabolites with exchangeable protons is measured. The protons of the metabolites, which may be studied using CEST, are able to exchange positions with protons from water. A saturation pulse may be used to suppress the MRI signal from the exchangeable protons of the metabolites. Due to their exchangeability, the protons of the metabolites trade places with the water protons. Since the protons from the metabolites were targeted with a saturation pulse, they do not contribute to the measured MRI signal for a period of time. This is true even when the protons from the metabolites were exchanged with the water protons. Therefore, the exchange of protons has the effect of reducing the measured MRI signal from the water. By performing saturation pulses at different frequency offsets and measuring the effect on the measured MRI signal, information about the presence of dilute metabolites or other substances may be determined. There is a variety of techniques that are related to the CEST technique. One example is amide proton transfer (APT) weighted MRI, which is a magnetic resonance (MR)-based molecular imaging of endogenous cytosolic proteins or peptides.

SUMMARY

The invention provides for a magnetic resonance imaging system, a method, and a computer program in the independent claims. Embodiments are given in the dependent claims.

In one aspect the invention provides for a magnetic resonance imaging system configured for acquiring magnetic resonance imaging data from a subject within an imaging zone. The magnetic resonance imaging system comprises a memory and a processor. The memory stores machine executable instructions and pulse sequence commands. The pulse sequence commands are configured to acquire the magnetic resonance imaging data according to a CEST magnetic resonance imaging protocol with spectral presaturation with inversion recovery (SPIR) fat suppression. The processor is configured to control the medical imaging system. An execution of the machine executable instructions by the processor causes the processor to control the magnetic resonance imaging system with the pulse sequence commands to acquire the magnetic resonance imaging data for a plurality of saturation frequencies. For a partial inversion pulse of the SPIR a varying flip angle is used, which is varied depending on the saturation frequencies being used.

In another aspect the invention provides for a method of operating a magnetic resonance imaging system for acquiring the magnetic resonance imaging data from a subject within an imaging zone. The magnetic resonance imaging system comprises a memory and a processor. The memory stores machine executable instructions and pulse sequence commands. The pulse sequence commands are configured to acquire the magnetic resonance imaging data according to a CEST magnetic resonance imaging protocol with SPIR fat suppression. The processor is configured to control the medical imaging system. An execution of the machine executable instructions by the processor causes the processor to control the magnetic resonance imaging system with the pulse sequence commands to perform the method, which comprises acquiring the magnetic resonance imaging data for a plurality of saturation frequencies. For a partial inversion pulse of the SPIR a varying flip angle is used, which is varied depending on the saturation frequencies being used.

In another aspect the invention provides for a computer program for acquiring magnetic resonance imaging data from a subject within an imaging zone. The computer program comprises machine executable instructions and pulse sequence commands. The pulse sequence commands are configured to acquire the magnetic resonance imaging data according to a CEST magnetic resonance imaging protocol with SPIR fat suppression. An execution of the machine executable instructions by a processor of a magnetic resonance imaging system causes the processor to control the magnetic resonance imaging system with the pulse sequence commands to acquire the magnetic resonance imaging data for a plurality of saturation frequencies. For a partial inversion pulse of the SPIR a varying flip angle is used, which is varied depending on the saturation frequencies being used.

BRIEF DESCRIPTION OF THE DRAWINGS

In the following preferred embodiments of the invention will be described, by way of example only, and with reference to the drawings in which:

Fig. 1 shows an exemplary diagram of a SPIR flip angle as a function of a saturation frequency and a target residual fat signal;

Fig. 2 shows an exemplary diagram of a SPIR flip angle as a function of a frequency relative to water;

Fig. 3 shows an exemplary diagram of a normalized magnitude signal from fat as a function of a saturation frequency for different protocols;

Fig. 4 shows a schematic diagram of an exemplary pulse sequence;

Fig. 5 shows an exemplary diagram of normalized mean pixel values for different regions of interest of a phantom using an APT-weighted protocol;

Fig. 6 shows an exemplary diagram of normalized mean pixel values for different regions of interest of a phantom using an APT-weighted protocol with constant flip angle SPIR;

Fig. 7 shows an exemplary diagram of normalized mean pixel values for different regions of interest of a phantom using an APT-weighted protocol with variable flip angle SPIR;

Fig. 8 shows another exemplary diagram of normalized mean pixel values for different regions of interest of a phantom using an APT-weighted protocol with variable flip angle SPIR;

Fig. 9 shows a flow chart which illustrates an example of a method for acquiring MRI data using a varying SPIR flip angle;

Fig. 10 illustrates an exemplary computational system for controlling an MRI system to acquire MRI data using a varying SPIR flip angle; and

Fig. 11 illustrates an exemplary MRI system configured for acquiring MRI data using a varying SPIR flip angle.

DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure, unless mutually exclusive. For the sake of brevity, however, the numerous iterations of these combinations will not be described separately. Features described in relation to a system, may be implemented in a computer implemented method and/or in a computer program product, in a corresponding manner.

Like numbered elements in the figures are either equivalent elements or perform the same function. Elements which have been discussed previously will not necessarily be discussed in later figures if the function is equivalent.

Examples may improve robustness and accuracy of fat suppression in CEST imaging, like APT-weighted imaging. Examples use a SPIR-based fat suppression with variable flip angle for this purpose and thereby provide for effective suppression of signal components from fat in CEST imaging. By suppressing and/or avoiding residual signals from fat, bias in the percentages displayed in CEST images, e.g., as APT-weighted images may be avoided.

This suppression may, e.g., be beneficial, when performing a magnetization transfer ratio (MTR) asymmetry analysis. When performing CEST, measurements may, e.g., be made at saturation frequency offsets symmetrically around the resonance frequency of water. This is done because the saturation pulses may also have an effect on the water signal. By making measurements symmetrically above and below the water resonance, the two can be compared and one measurement can be used as a baseline. However, the presence of fat, e.g., in the human body, can disrupt this.

Hence, the presence of a fat signal is a major impediment to the translation of CEST, e.g., APT-weighted, magnetic resonance imaging to applications in the body. Any residual fat signal may lead, e.g., in combination with an MTR asymmetry analysis, to considerable bias in the percentages displayed as APT-weighted images, or in any other type of CEST images.

For example, APT-weighted images may be particularly affected by residual fat signal, when saturating at -3.5 ppm, due to the proximity to the dominant methylene peak of fat at -3.4 ppm. Similarly, Hydroxyl (OH)-CEST may, e.g., be impacted by residual fat signal, when saturating at $\pm 1.0$ ppm, due to the proximity to the olefinic and glycerol peaks of fat at +0.6 ppm and $\pm 0.5$ ppm, respectively.

Examples using a SPIR-based fat suppression with a variable flip angle of the partial inversion pulse of SPIR, which is varied depending on the saturation frequencies used for the CEST imaging, may provide an effective suppression of signal components from fat. Such an effective suppression may be sufficient to resolve the aforementioned problems caused by fat in CEST imaging, e.g., when performing an MTR asymmetry analysis.

CEST refers to the chemical exchange saturation transfer protocol for magnetic resonance imaging. SPIR refers to a spectral presaturation with inversion recovery, which is used in magnetic resonance imaging, in particular in CEST imaging, to suppress signal from fat. Using SPIR detrimental effects of signals from fat, e.g., when performing an MTR asymmetry analysis, may be reduced. The extent of fat suppression achieved using SPIR may vary with the frequency of the saturation pulse, the flip angle of the partial inversion pulse, and the fat composition, i.e. the fat spectrum. Using SPIR with a varying flip angle of the partial inversion pulse, which is adjusted to the saturation frequency, i.e. the frequency of the saturation pulse being used, the fat suppression may be increased. The flip angle may be varied, i.e. different flip angle values to be used for different saturation frequencies may be determined such that a desired residual total longitudinal magnetization of fat is reached at the time, when an excitation pulse for the magnetic resonance imaging data acquisition is applied. For determining the respective values of the flip angle of the partial inversion pulse of SPIR, also the fat spectrum and its influence on the fat suppression may be taken into account.

SPIR is a hybrid technique that combines a fat-selective radio frequency (RF) pulse, i.e. a partial inversion pulse, and a spoiler gradient. Through an inversion delay mechanism, a nulling of the residual longitudinal fat magnetization may be achieved. SPIR is intended to invert the fat magnetization partially or completely. The partial inversion pulse, at least partially, inverts the magnetization from tissue components resonant at a frequency selected for the partial inversion pulse, e.g., fat. Any transverse magnetization components of fat created by this partial inversion pulse are dephased by the spoiler gradient. A spoiler magnetic field gradient pulse is configured and used to effectively remove transverse magnetization by producing a rapid variation of its phase along the direction of the gradient. The residual inverted longitudinal magnetization $M_z$ of fat is then allowed to regrow via T1 relaxation. MRI signal generation may begin, when the $M_z$ of fat is zero, such that fat does not contribute to the final image.

Examples may not use a constant flip angle of the partial inversion pulse of SPIR for different saturation frequencies. Examples may vary the flip angle of the partial inversion pulse of SPIR depending on the saturation frequencies being used. Depending on the saturation frequency, the flip angle may be selected such that a desired suppression of fat with a desired residual total longitudinal magnetization of fat is achieved. Thus, disturbing contributions from fat may be effectively suppressed for a plurality of different saturation frequencies.

For example, the CEST magnetic resonance imaging protocol is an APT-weighted magnetic resonance imaging protocol. The APT-weighted magnetic resonance imaging protocol may implement CEST imaging at an offset frequency of 3.5 ppm.

Examples may enable an equalizing of the extent of fat suppression at symmetric frequencies of a saturation pulse relative to the resonance frequency of water. The flip angle of SPIR may be varied with the frequency of the saturation pulse for this purpose. A residual signal from fat may then be eliminated by post-processing, e.g., by an MTR asymmetry analysis.

Examples may be beneficially applicable to APT-weighted magnetic resonance imaging and other CEST magnetic resonance imaging, as they may enable an equalizing of the residual fat signal over a large range of different frequencies of the saturation pulse, i.e. over a large range of different saturation frequencies.

APT is a technique for MR-based molecular imaging of endogenous cytosolic proteins or peptides. It is based on the CEST effect and reflects protein concentrations as well as local pH via the exchange rate. Clinical applications of APT MRI may, e.g., comprise oncology in view of enhanced protein concentrations in tumors and neurology in view of acidosis in ischemic stroke. The detection of amide protons may be based on an MTR asymmetry analysis on the water signal using symmetric RF saturation frequency offsets of $\pm$ 3.5 ppm around the water resonance, while the APT-weighted signal is found as an image signal reduction around + 3.5 ppm. Measuring the asymmetry of the signal amplitude as function of the saturation frequency offset is inherently sensitive to confounding signal contributions around -3.5 ppm, overlapping with the chemical shift range of fat signals. Fat signals may particularly influence APT-weighted imaging in fat-containing tissues or via partial volume effects, when voxels are chosen close to water-fat interfaces. Therefore, using SPIR, which provides a fat suppression pulse, in APT-weighted or CEST MRI sequences may have the beneficial effect of accommodating for this problem.

Amide proton transfer-weighted imaging may rely on magnetization transfer ratio (MTR) asymmetry analysis to extract a saturation transfer effect. While allowing fast volumetric imaging with minimal Z-spectral coverage, it is highly susceptible to fat signals at various chemical shifts. Fat suppression, by SPIR, for instance, is a way to reduce resulting artifacts. An adaptation of the flip angle of SPIR with the saturation frequency offset according to examples may allow for equalizing the residual fat signal across the entire Z-spectrum. Thus, examples may be able to avoid fat signal artifacts in the MTR asymmetry analysis.

For example, the CEST magnetic resonance imaging protocol may be any other CEST magnetic resonance imaging protocol besides the APT-weighted magnetic resonance imaging protocol.

For example, the acquired magnetic resonance imaging data is Z-spectrum imaging data for the plurality of saturation frequencies. Z-spectrum image data as used herein is data which may be in the form of or may be suitable for generating a Z-spectrum or Z-spectrum image.

For example, the Z-spectrum imaging data is used for a magnetization transfer ratio asymmetry analysis. For providing a Z-spectrum, magnetic resonance data for multiple images $S[\omega]$ may be recorded with a variable saturation frequency offset $\omega$. The resulting Z-spectrum may be used for a normalized assessment of $MTR_{asym} = (S[-\omega] - S[+\omega]) / S_0$, where $S[-\omega]$ and $S[+\omega]$ are the signal intensities obtained by saturation at the negative and positive sides of the respective CEST spectrum, i.e. the Z-spectrum, respectively, and So is the signal intensity of bulk water without saturation used for the normalization. For this purpose, the APT-weighted image acquisition scheme may use acquisitions at different saturation frequency offsets $\omega$. It is understood that also other Z-spectrum analysis methods may profit from a constant fat signal. Therefore, the acquired Z-spectrum imaging data may, e.g., be used for other Z-spectrum analysis methods as well.

For example, the execution of the machine executable instructions further causes the magnetic resonance imaging system to receive a specification of a desired residual total longitudinal magnetization of fat, which is constant over the saturation frequencies, for a time, when an excitation pulse for the magnetic resonance imaging data acquisition is applied. Thus, the desired residual total longitudinal magnetization of fat is chosen to be the same, i.e. constant, for all the saturation frequencies of the plurality of saturation frequencies. For example, the execution of the machine executable instructions further causes the magnetic resonance imaging system to determine for the saturation frequencies flip angle values for varying the flip angle. The flip angle values, e.g., depend on the saturation frequencies and are determined to achieve the desired residual total longitudinal magnetization of fat. For example, for each saturation frequency of the plurality of saturation frequencies a flip angle value is determined, such that using a partial inversion pulse of the SPIR with a flip angle of the determined flip angle value for the respective saturation frequency results in the desired residual total longitudinal magnetization of fat.

For example, the flip angle values are determined using the following relation:

$$M_z(T_D) = \sum_n w_n \left( \left( \left( \left( M_{z,n}(-T_S-T_P) \frac{(f_S-f_n)^2}{I^2+(f_S-f_n)^2} - 1 \right) e^{-T_P/T_{1,n}} + 1 \right) \cos(\alpha_n) - 1 \right) e^{-T_D/T_{1,n}} + 1 \right).$$

In the equation above, $M_z$ denotes the time dependent desired residual total longitudinal magnetization of fat. $M_{z,n}$ denotes a time dependent longitudinal magnetization of an n-th component of fat, which is taken into account. $T_D$ denotes a delay time, at which the excitation pulse for the magnetic resonance imaging data acquisition is applied. $T_S$ denotes a duration of a saturation pulse. $T_P$ denotes a time between applying the saturation pulse and applying the partial inversion pulse. Furthermore, fs denotes the saturation frequency, while $w_n$ denotes the fraction of the total longitudinal magnetization resulting from the n-th component of fat, which is taken into account, i.e. the relative areas of the peaks, and $f_n$ denotes a resonance frequency of the n-th component of fat, which is taken into account. $T_{1,n}$ denotes a longitudinal relaxation time constant of the n-th component of fat, which is taken into account, and $\alpha_n$ denotes a flip angle of the n-th component of fat which is taken into account. This flip angle $\alpha_n$ of the n-th component is linked to the flip angle value $\alpha$ to be determined by a fixed factor, which is defined by a spectral profile of the partial inversion pulse: $\alpha_n = \beta_n \alpha$. Here, $\beta_n$ denotes a fixed factor, by which the flip angle $\alpha_n$ of the n-th component is linked to the flip angle value $\alpha$ and which is defined by the spectral profile of the partial inversion pulse.

SPIR comprises a fat-selective partial inversion pulse with flip angle $\alpha$, a spoiler gradient that dephases any transverse magnetization created by the partial inversion pulse, and a relatively short delay time $T_D$. Assuming a single-peak spectrum of fat and an infinitely short partial inversion pulse, the effect of SPIR on the longitudinal magnetization $M_z$ of fat at a time t may be described by

$$M_z(t) = (M_z(0^-) \cos(\alpha) - 1) e^{-t/T_1} + 1.$$

$M_z(0^-)$ denotes the fraction of the longitudinal magnetization before application of SPIR at t = 0 and $T_1$ denotes the longitudinal relaxation time constant of fat. The flip angle $\alpha$ may be chosen such that $M_z(t)$ crosses zero at time t = $T_D$, when the excitation pulse for the subsequent imaging is applied.

Considering a multi-peak spectrum of fat, the equation for $M_z(t)$ turns into

$$M_z(t) = \sum_n w_n \left( \left( M_{z,n}(0^-) \cos(\alpha_n) - 1 \right) e^{-t/T_{1,n}} + 1 \right),$$

where n indexes individual peaks of the spectrum of fat and $w_n$ denotes corresponding fractions of the longitudinal magnetization.

SPIR is preceded by a saturation pulse with a duration $T_S$ and a frequency $f_S$. Its effect on $M_{z,n}(0^-)$ may be modelled with a Lorentzian

$$M_{z,n}(0^-)=\left(M_{z,n}(-T_S-T_P)\frac{(f_S-f_n)^2}{l^2+(f_S-f_n)^2}-1\right)e^{-T_P/T_{1,n}}+1.$$

Here, $M_{z,n}(-T_S-T_P)$ denotes the fraction of the longitudinal magnetization before application of the saturation pulse. $T_P$ denotes the time between the saturation pulse and the partial inversion pulse and l denotes a half width at half maximum of the Lorentzian.

Inserting the equation above for $M_{z,n}(0^-)$ into the equation for $M_z(t)$ in case of a multi-peak spectrum of fat results at time $t = T_D$, when the excitation pulse for the subsequent imaging is applied, in the equation for $M_z(T_D)$ cited above:

$$M_z(T_D)=\sum_n w_n\left(\left(\left(M_{z,n}(-T_S-T_P)\frac{(f_S-f_n)^2}{l^2+(f_S-f_n)^2}-1\right)e^{-T_P/T_{1,n}}+1\right)\cos(\alpha_n)-1\right)e^{-T_D/T_{1,n}}+1\right).$$

The flip angles $\alpha_n$ for the individual peaks are linked to the nominal flip angle $\alpha$ by the aforementioned fixed factors, which are defined by the spectral profile of the partial inversion pulse.

For example, the relation is solved for the flip angle values numerically. For each saturation frequency of the plurality of saturation frequencies, a value of the flip angle $\alpha$ may thus be determined. In the analytic equation for $M_z(T_D)$ cited above, given the $\alpha_n$, the respective nominal flip angle $\alpha$ may be calculated for a desired $M_z(T_D)$ numerically using the respective saturation frequency. The flip angles $\alpha_n$ of the n-th components are each linked to the flip angle value $\alpha$ to be determined by a fixed factor, which is defined by a spectral profile of the partial inversion pulse: $\alpha_n = \beta_n \alpha$. These fixed factor $\beta_n$, by which the flip angle $\alpha_n$ of the n-th components are linked to the flip angle value $\alpha$, are defined by the spectral profile of the partial inversion pulse.

For example, the relation is solved for the flip angle values using an analytical approximation of the relation.

Such an analytical approximation may take into account several simplifications. For the sake of simplicity, e.g., the fixed factors linking the peak-specific flip angles $\alpha_n$ to the nominal flip angle $\alpha$ may be set to 0 for $n_W$ peaks of fat close to the peak of water, namely the olefinic peak at +0.6 ppm and the glycerol peaks at $\pm 0.5$ ppm relative to water, and to 1 for all other $n_F$ peaks of fat. Then, the equation for $M_z(T_D)$ cited above reduces to

$$M_z(T_D)=\sum_{n_W} w_{n_W}M_{z,n_W}(-T_S-T_P)\frac{(f_S-f_{n_W})^2}{l^2+(f_S-f_{n_W})^2}\ e^{-T_P/T_{1,n_W}}\ e^{-T_D/T_{1,n_W}}$$

$$+\cos(\alpha)\sum_{n_F} w_{n_F}M_{z,n_F}(-T_S-T_P)\frac{(f_S-f_{n_F})^2}{l^2+(f_S-f_{n_F})^2}\ e^{-T_P/T_{1,n_F}}\ e^{-T_D/T_{1,n_F}}$$

$$-\sum_{n_W} w_{n_W}\ e^{-T_P/T_{1,n_W}}\ e^{-T_D/T_{1,n_W}}-\cos(\alpha)\sum_{n_F} w_{n_F}\ e^{-T_P/T_{1,n_F}}\ e^{-T_D/T_{1,n_F}}$$

$$+\sum_{n_W} w_{n_W}\ e^{-T_D/T_{1,n_W}}+\cos(\alpha)\sum_{n_F} w_{n_F}\ e^{-T_D/T_{1,n_F}}$$

$$-\sum_n w_n\ e^{-T_D/T_{1,n}}+\sum_n w_n\ .$$

Further, the differences in $T_1$ may be ignored and the w may be assumed to add up to 1 resulting in

$$M_z(T_D)=e^{-(T_P+T_D)/T_1}\sum_{n_W} w_{n_W}M_{z,n_W}(-T_S-T_P)\frac{(f_S-f_{n_W})^2}{l^2+(f_S-f_{n_W})^2}$$

$$+\cos(\alpha)\ e^{-(T_P+T_D)/T_1}\sum_{n_F} w_{n_F}M_{z,n_F}(-T_S-T_P)\frac{(f_S-f_{n_F})^2}{l^2+(f_S-f_{n_F})^2}$$

$$-e^{-(T_P+T_D)/T_1}\sum_{n_W} w_{n_W}-\cos(\alpha)\ e^{-(T_P+T_D)/T_1}\sum_{n_F} w_{n_F}$$

$$+e^{-T_D/T_1}\sum_{n_W} w_{n_W}+\cos(\alpha)\ e^{-T_D/T_1}\sum_{n_F} w_{n_F}$$

$$-e^{-T_D/T_1}+1$$

The flip angle $\alpha$ for this approximation may then analytically be calculated by

$$\alpha=\mathrm{acos}\left(\frac{1+e^{T_D/T_1}(M_z(T_D)-1)-e^{-T_P/T_1}\sum_{n_W}w_{n_W}M_{z,n_W}(-T_S-T_P)\frac{(f_S-f_{n_W})^2}{l^2+(f_S-f_{n_W})^2}-(1-e^{-T_P/T_1})\sum_{n_W}w_{n_W}}{e^{-T_P/T_1}\sum_{n_F}w_{n_F}M_{z,n_F}(-T_S-T_P)\frac{(f_S-f_{n_F})^2}{l^2+(f_S-f_{n_F})^2}+(1-e^{-T_P/T_1})\sum_{n_F}w_{n_F}}\right).$$

For example, the desired residual total longitudinal magnetization of fat is zero. Using a desired residual total longitudinal magnetization of fat of zero may have the beneficial effect that the flip angle may be varied such that the resulting actual residual total longitudinal magnetization of fat is minimized.

For example, the desired residual total longitudinal magnetization of fat is non-zero. Using a non-zero desired residual total longitudinal magnetization of fat for determining the variation of the flip angle, i.e. the different flip angle values to be used for the different saturation frequencies, may have the beneficial effect that resulting actual residual total longitudinal magnetization of fat may not be minimized, but may be more symmetrical relative to the saturation frequency of water, than in case of using a zero desired residual total longitudinal magnetization of fat.

For example, in case of a symmetry-based analysis, like in case of an MTR asymmetry analysis, minimized asymmetric fat contributions may have a stronger detrimental impact on the results than non-minimized symmetric fat contributions, which cancel out in the symmetry-based analysis.

For example, the desired residual total longitudinal magnetization of fat lies within a range from 1% to 20%. For example, the desired residual total longitudinal magnetization of fat lies within a range from 5% to 15%. For example, the desired residual total longitudinal magnetization of fat lies within a range from 9% to 11%.

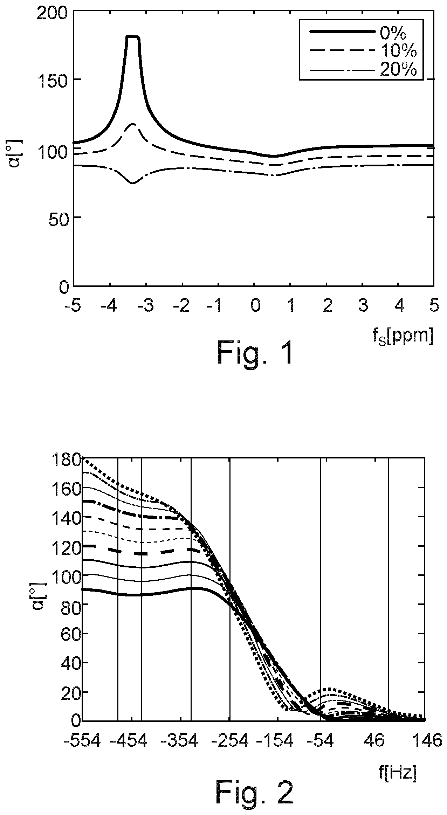

Figs. 1 to 8 illustrate proof-of-concept experiments using a phantom with sunflower oil high in polyunsaturated fatty acids. The exemplary approach proposed herein is demonstrated to equalize the residual fat signal at corresponding positive and negative saturation frequency offsets and may thus cancel the residual fat signal in the MTR asymmetry analysis. Variable flip angle SPIR may therefore largely alleviate artifacts from fat signal in CEST imaging, e.g., APT-weighted imaging, without prolonging the acquisition or requiring elaborate post-processing. For these proof-of-concept experiments in the phantom a turbo spin-echo (TSE) sequence was used.

Fig. 1 illustrates a flip angle $\alpha$ of SPIR as a function of a frequency fs of a saturation pulse in ppm and a target residual fat signal $M_z(T_D)$ in % at time t =$T_D$ according to the equation

$$\alpha=\mathrm{acos}\left(\frac{1+e^{T_D/T_1}(M_z(T_D)-1)-e^{-T_P/T_1}\sum_{n_W}w_{n_W}M_{z,n_W}(-T_S-T_P)\frac{(f_S-f_{n_W})^2}{l^2+(f_S-f_{n_W})^2}-(1-e^{-T_P/T_1})\sum_{n_W}w_{n_W}}{e^{-T_P/T_1}\sum_{n_F}w_{n_F}M_{z,n_F}(-T_S-T_P)\frac{(f_S-f_{n_F})^2}{l^2+(f_S-f_{n_F})^2}+(1-e^{-T_P/T_1})\sum_{n_F}w_{n_F}}\right).$$

The flip angle $\alpha$ of SPIR required to equalize the residual signal $M_z(T_D)$ from fat is illustrated in Fig. 1 for an example of a simplified six-peak spectrum of sunflower oil high in polyunsaturated fatty acids with resonance frequencies $f_{1F}$= -3.8 ppm, $f_{2F}$= -3.4 ppm, $f_{3F}$= -2.6 ppm, $f_{4F}$= -2.0 ppm, $f_{1W}$= -0.5 ppm, $f_{2W}$= +0.6 ppm, and fractions of the total longitudinal magnetization $w_{1F}$=8.9 %, $w_{2F}$=57.7 %, $w_{3F}$=16.5 %, $w_{4F}$=3.4 %, $w_{1W}$=4.0 %, $w_{2W}$=9.6 %. The ratios $T_D$/T1 and TP/T1 were set to 0.0385 and 0.0186, respectively, and the fraction $M_z(-T_S-T_P)$ of the longitudinal magnetization before application of the saturation pulse was set to 1.0. The half width at half maximum l was determined separately without SPIR. The magnitude of the fat signal was normalized by the magnitude of the water signal measured with high $f_S$.

For a target residual fat signal of 0%, i.e. $M_z(T_D)$ = 0, the flip angle of SPIR is around 100°, except close to -3.4 ppm, where it increases rapidly. At -3.4 ppm, even with a flip angle of 180°, the target of $M_z(T_D)$ = 0 is not reached anymore. For a target residual fat signal of 10%, i.e., $M_z(T_D)$ = 0.1, the target may always be reached with a small variation of the flip angle. The same holds true for a target residual fat signal of 20%, i.e., $M_z(T_D)$ = 0.2, with the difference that a smaller flip angle is required at -3.4 ppm than elsewhere. Thus, for a target residual fat signal of 0%, i.e. $M_z(T_D)$ = 0, not for all the relevant saturation frequencies, a flip angle of SPIR can be determined, which is able to ensure the target residual fat signal. This may result in slight residual asymmetries, when using this specification for a minimum target residual fat signal. However, when using a target residual fat signal of 10% or 20%, the actual resulting residual fat signal may not be minimal, but more symmetric, since a flip angle of SPIR can be determined for all the relevant saturation frequencies.

Fig. 2 illustrates an actual flip angle $\alpha$ of SPIR as a function of a frequency f relative to water in Hz for a nominal flip angle of 90° to 180°, reached at the center frequency of -554 Hz (-4.3 ppm). The vertical lines indicate the frequencies of six considered peaks of fat in case of sunflower oil high in polyunsaturated fatty acids. The actual flip angle of the partial inversion pulse may deviate from the nominal flip angle, to varying extent for the individual peaks of fat. This is demonstrated in Fig. 2 with one specific partial inversion pulse, with which an actual flip angle close to 160° is reached at best for a nominal flip angle of 180° at the frequency of the main peak of fat at - 3.4 ppm, i.e., -434 Hz. Such prior knowledge can readily be considered in the equation for $M_z(T_D)$ cited above, i.e.

$$M_z(T_D)=\sum_n w_n \left(\left(\left(\left(M_{z,n}(-T_S-T_P)\frac{(f_S-f_n)^2}{l^2+(f_S-f_n)^2}-1\right)e^{-T_P/T_{1,n}}+1\right)\cos(\alpha_n)-1\right)e^{-T_D/T_{1,n}}+1\right).$$

Other partial inversion pulses, such as $B_1$-insensitive rotation (BIR) pulses, may be employed, which may perform better in this regard at the expense of duration.

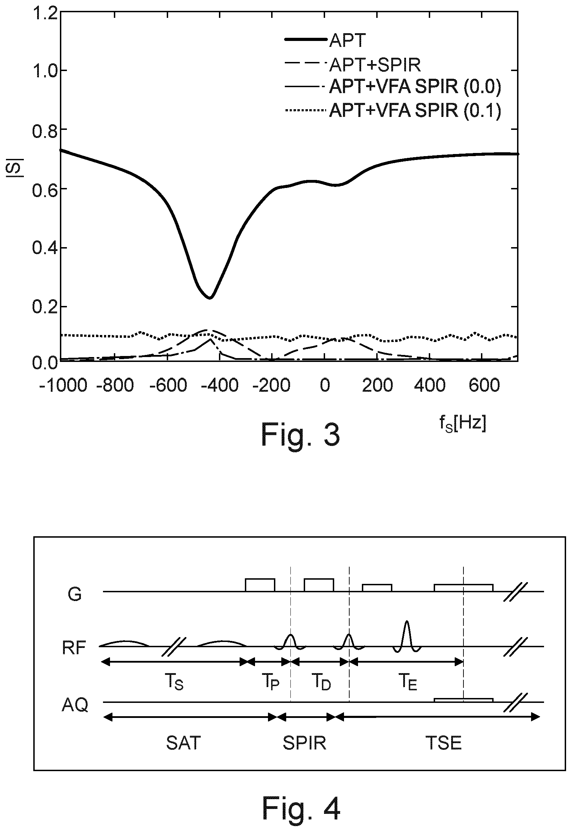

Fig. 3 illustrates, using a Z-spectrum, a normalized magnitude signal |S| from fat as a function of a frequency of a saturation pulse in Hz for an APT-weighted protocol, an APT-weighted protocol with constant flip angle SPIR, an APT-weighted protocol with variable flip angle SPIR for a target residual fat signal of 0%, and an APT-weighted protocol with variable flip angle SPIR for a target residual fat signal of 10%. A phantom constructed of sunflower oil high in polyunsaturated fatty acids and of doped water was imaged with various $f_S$ without SPIR, with conventional SPIR, and with a variable flip angle SPIR. Plotted in Fig. 3 is the residual signal from fat measured in this phantom. Using APT-weighted imaging with constant flip angle SPIR, the fat suppression degrades around the two peaks of fat at -3.4 ppm, i.e. -434 Hz, and +0.6 ppm, i.e. +77 Hz. With a variable flip angle SPIR and a target residual fat signal of 0%, the residual signal from fat improves clearly around the peak of fat at +0.6 ppm, but only slightly around the peak of fat at -3.4 ppm, due to the insufficient actual and even nominal flip angle. A consistent extent of fat suppression is achieved by raising the target residual fat signal to 10%, for example. It may be worth noting that an insufficient nominal flip angle may not be expected to occur in vivo, because of the much lower degree of unsaturation of animal fats.

Fig. 4 illustrates a schematic diagram of the used sequence comprising RF saturation (SAT) of duration $T_S$, SPIR with flip angle $\alpha$ and delay $T_D$, and TSE imaging with short echo time TE. Shown in Fig. 4 are the readout gradient (G), RF transmission (RF), and data acquisition (AQ).

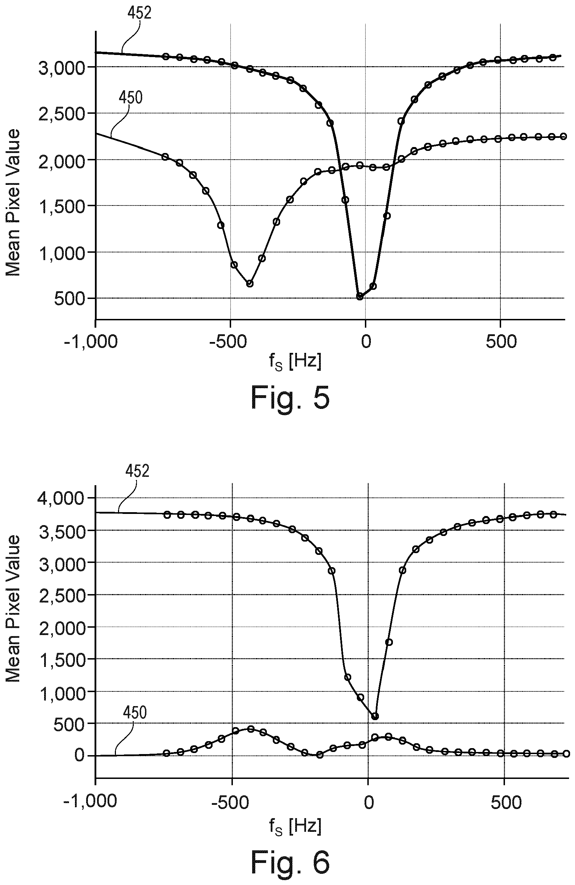

Figs. 5 to 8 illustrate, using the same phantom as before, Z-spectra of normalized mean pixel values acquired from a first region of interest within the sunflower oil high in polyunsaturated fatty acids, illustrated by graph 450, and from a second region of interest within the doped water, illustrated by graph 452. The sunflower oil high in polyunsaturated fatty acids comprises 11% saturated, 32% mono-unsaturated, i.e. oleic, and 57% poly-unsaturated, i.e. linoleic, fatty acids. The probe is characterized by a chain length cl = 18, a number of double bonds ndb = 1.46, and a number of methylene-interrupted double bonds nmidb = 0.57. The fat spectrum of the sunflower oil comprises six peaks, with the following portion of the spectrum: First peak at -3.8 ppm, i.e. -484 Hz, 8.9%; second peak at -3.4 ppm, i.e. -433 Hz, 57.7%; third peak at -2.6 ppm, i.e. -331 Hz, 16.5%; fourth peak at -2.0 ppm, i.e. -248 Hz, 3.4%; fifth peak at -0.5 ppm, i.e. -64 Hz, 4.0%; and sixth peak at +0.6 ppm, i.e. +76 Hz, 9.6%.

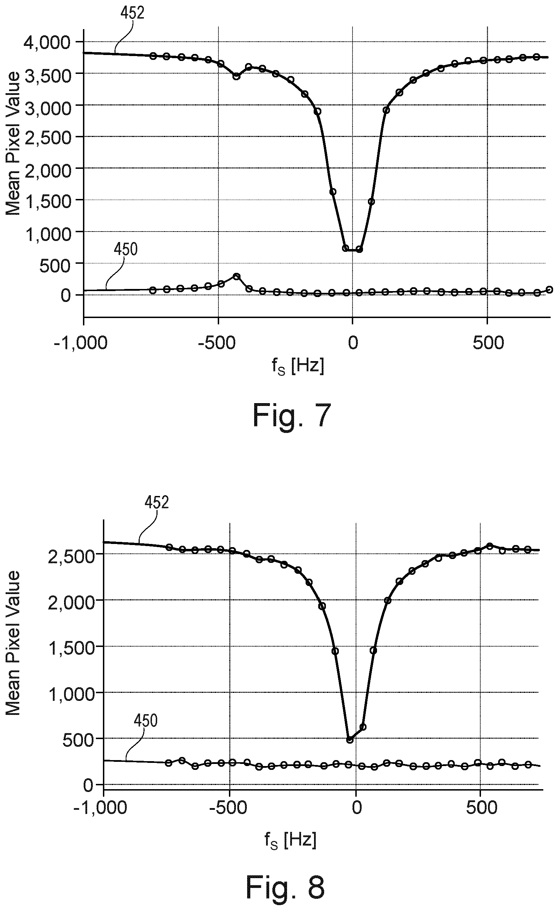

In Fig. 5, results are shown for using an APT-weighted protocol. In Fig. 6, results are shown for using an APT-weighted protocol with constant flip angle SPIR. In Fig. 7, results are shown for using an APT-weighted protocol with variable flip angle SPIR and a target residual fat signal of 0%. In Fig. 8 results are shown for using an APT-weighted protocol with variable flip angle SPIR with a target residual fat signal of 10%. As can be seen from a comparison of Figs. 5 and 6 using SPIR results in a significant suppression of the fat signal. This suppression is effectively increased, when using SPIR with a variable flip angle as illustrated in Figs. 7 and 8. Comparing Figs. 7 and 8, it can be seen that using a target residual fat signal of 0% may result in a smaller actual residual fat signal compared to using a small, but non-zero target residual fat signal, like 10% in Fig. 8. However, the actual residual fat signal in case of the non-zero target residual fat signal of Fig. 8 is more symmetric relative to the saturation frequency of water, than in case of the zero target residual fat signal of Fig. 7. In case of a symmetry-based analysis, like in case of an MTR asymmetry analysis, minimized asymmetric fat contributions may have a stronger impact on the results than non-minimized symmetric fat contributions, which cancel out in the symmetry-based analysis. Thus, a non-zero target residual fat signal, like in Fig. 8, may in some cases be preferable to a zero-target residual fat signal.

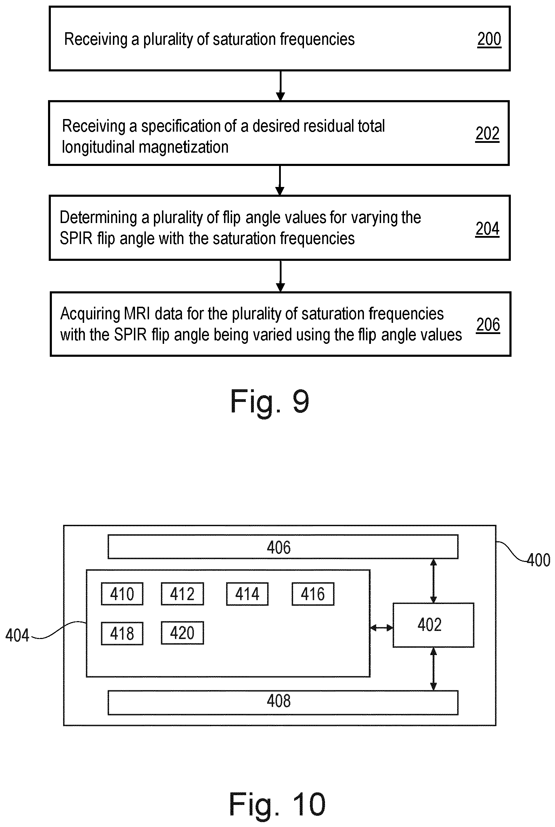

Fig. 9 illustrates an exemplary method for acquiring magnetic resonance imaging data from a subject within an imaging zone using a variable SPIR flip angle. For executing the method, e.g., a computational system is used, which is configured for controlling a magnetic resonance system. The computational system comprises a memory and a processor. The memory stores machine executable instructions and pulse sequence commands. The pulse sequence commands are configured to acquire the magnetic resonance imaging data according to a CEST magnetic resonance imaging protocol with SPIR fat suppression.

In block 200 or step 200, a plurality of saturation frequencies is received, for which magnetic resonance imaging data is to be acquired using the magnetic resonance system with the CEST magnetic resonance imaging protocol with SPIR fat suppression. For example, the CEST protocol is an APT-weighted magnetic resonance imaging protocol, which is executed with SPIR fat suppression. The saturation frequencies of the plurality of saturation frequencies may, e.g., be received in form of a user input and/or a user selection of frequencies or frequency offsets relative to the saturation frequency of water. For example, the saturation frequencies of the plurality of saturation frequencies are predefined frequencies, which are predefined for a specific magnetic imaging data acquisition procedure to be executed. For example, the plurality of saturation frequencies may be stored in the memory of the computational system. For example, the receiving of the plurality of saturation frequencies may comprise reading the saturation frequencies of the plurality of saturation frequencies from the memory. For example, the plurality of saturation frequencies may be received from an external storage medium, e.g., from a local storage medium, like a USB storage device, or a via a network from a remote storage medium, like a cloud storage.

In block 202, a specification of a desired residual total longitudinal magnetization of fat to be achieved by a time, when an excitation pulse for the magnetic resonance imaging data acquisition is applied, is received. The desired residual total longitudinal magnetization of fat is constant over the saturation frequencies of the plurality of saturation frequencies, i.e. it is chosen to be the same for all the saturation frequencies. The specification of the desired residual magnetization may, e.g., be received in form of a user input and/or a user selection. For example, the specification of the desired residual magnetization is a predefined specification, which is predefined for a specific magnetic imaging data acquisition procedure to be executed. For example, the specification of the desired residual magnetization may be stored in the memory of the computational system. For example, the receiving of the specification of the desired residual magnetization may comprise reading the specification of the desired residual magnetization from the memory. For example, the specification of the desired residual magnetization may be received from an external storage medium, e.g., from a local storage medium, like a USB storage device, or a via a network from a remote storage medium, like a cloud storage. The desired residual total longitudinal magnetization of fat may, e.g., be zero. The desired residual total longitudinal magnetization of fat may, e.g., be non-zero. For example, the desired residual total longitudinal magnetization of fat lies within a range from 1% to 20%, preferably 5% to 15%, and more preferably 9% to 11%.

In block 204, a plurality of flip angle values is determined for varying the flip angle of the partial inversion pulse of the SPIR with the saturation frequencies of the plurality of saturation frequencies. For the determining, e.g., the plurality of saturation frequencies received in block 200 and the specification of the desired residual magnetization received in block 202 may be used. For example, a flip angle value may be determined for each of the saturation frequencies of the plurality of saturation frequencies, such that the desired residual magnetization according to the specification is achieved by the time, when the excitation pulse for the magnetic resonance imaging data acquisition is applied. Thus, each of the flip angle values may be assigned to one of the saturation frequencies. The determining of the flip angle values may comprise computing the different flip angle values for the different saturation frequencies numerically using the specification of the desired residual magnetization. The determining of the flip angle values may comprise computing the different flip angle values for the different saturation frequencies using an analytical approximation for the interdependency of flip angle value, saturation frequency, and desired residual magnetization.

For example, the flip angle values of the plurality of flip angle values are predetermined values, which are predetermined for a specific plurality of saturation frequencies and a specific desired residual magnetization, which are to be used for a specific magnetic imaging data acquisition procedure. For example, the plurality of flip angle values may be stored in the memory of the computational system. For example, the determining of the plurality of flip angle values may comprise reading the flip angle values of the plurality of flip angle values from the memory. For example, the determining of the plurality of flip angle values may comprise receiving the plurality of flip angle values from an external storage medium, e.g., from a local storage medium, like a USB storage device, or a via a network from a remote storage medium, like a cloud storage.

In block 206, the magnetic resonance imaging system is controlled with the pulse sequence commands to acquire the magnetic resonance imaging data for the plurality of saturation frequencies. Magnetic resonance imaging data may be acquired for each of the saturation frequencies of the plurality of saturation frequencies. For a partial inversion pulse of the SPIR a varying flip angle is used, which is varied depending on the saturation frequencies being used. For varying the flip angle, the determined flip angle values of the plurality of flip angle values are used. For each saturation frequency, the assigned flip angle value for the partial inversion pulse of the SPIR may be used, thus varying the flip angle with the saturation frequency.

For example, the acquired magnetic resonance imaging data may be Z-spectrum imaging data for the plurality of saturation frequencies. The acquired Z-spectrum imaging data may, e.g., be used for a magnetization transfer ratio asymmetry analysis.

Fig. 10 illustrates an exemplary computational system 400 for controlling a magnetic resonance imaging system configured for acquiring magnetic resonance imaging data from a subject within an imaging zone. The computational system 400 is shown as comprising a computational component 402. The computational component 402 is intended to represent one or more processors or processing cores or other computational elements. The computational component 402 is shown as being connected to a hardware interface 406 and a memory 404. The hardware interface 406 may enable the computational component 402 to exchange commands and data with other components. The hardware interface 406 may, e.g., enable the computational component 402 to control a magnetic resonance imaging system. The hardware interface 406 may also comprise network components so that the computational component 402 can send and receive data via a computer network.

The computational component 402 is further shown as being connected to a user interface 408 which may for example enable an operator to control and operate the computational system 400 and via the computational system 400, e.g., a magnetic resonance imaging system. The user interface 408 may, e.g., comprise an output and/or input device enabling a user to interact with the computational system 400. The output device may, e.g., comprise a display device configured for displaying magnetic resonance images reconstructed using magnetic resonance imaging data acquired using a magnetic resonance imaging system. The input device may, e.g., comprise a keyboard and/or a mouse enabling the user to insert control commands for controlling the computational system 400 and via the computational system 400 the magnetic resonance imaging system.

The memory 404 is shown as containing machine-executable instructions 410. The machine-executable instructions 410 enable the computational component 402 to perform controlling tasks, such as controlling the magnetic resonance imaging system, to perform numerical tasks, as well as performing various signal data processing tasks, like generating a Z-spectrum and/or performing a magnetization transfer ratio asymmetry analysis. When controlling the magnetic resonance imaging system, the computational component 402 may use pulse sequence commands 412 to acquire magnetic resonance imaging data 414 for a plurality of saturation frequencies 416. The pulse sequence commands 412 may be configured to acquire the magnetic resonance imaging data 414 according to a CEST magnetic resonance imaging protocol with SPIR fat suppression, e.g., an APT-weighted magnetic resonance imaging protocol with SPIR fat suppression. For a partial inversion pulse of the SPIR a varying flip angle may be used, which is varied depending on the saturation frequencies being used. The exemplary computational system 400 may, e.g., be configured to execute the method of Fig. 9 for acquiring the magnetic resonance imaging data 414 using pulse sequence commands 412. For this purpose, a specification of the plurality of saturation frequencies 416 and a specification of a desired residual total longitudinal magnetization 418 of fat at a time, when an excitation pulse for the magnetic resonance imaging data acquisition is applied, may be received. The specification of the plurality of saturation frequencies 416 and the specification of the desired residual magnetization 418 may be used to determine flip angle values 420 for varying the flip angle in dependency of the saturation frequencies of the plurality of saturation frequencies 416, in order to achieve the desired residual magnetization 418.

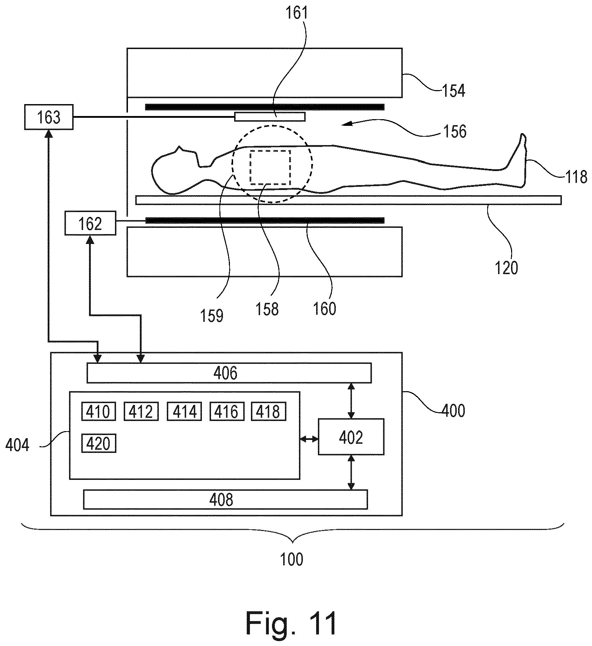

Fig. 11 illustrates an exemplary magnetic resonance imaging system 100 comprising the computational system 400 of Fig. 10. The magnetic resonance imaging system 100 is controlled by the computer 400. The magnetic resonance imaging system 100 comprises a magnet 154. The magnet 154 is a superconducting cylindrical type of magnet with a bore 156 through it. The use of different types of magnets is also possible. For instance, it is also possible to use both a split cylindrical magnet and a so-called open magnet. Inside a cryostat of the cylindrical magnet there is a collection of superconducting coils. Within the bore 156 of the cylindrical magnet 154 there is an imaging zone 159, where the magnetic field is strong and uniform enough to perform magnetic resonance imaging. A region of interest 158 is shown within the imaging zone 159. The magnetic resonance data is typically acquired for the region of interest 158. A subject 118 is shown as being supported by a subject support 120 such that at least a portion of the subject 118 is within the imaging zone 159 and the region of interest 158.

Within the bore 156 of the magnet there is also a set of magnetic field gradient coils 160 which is used for the acquisition of preliminary magnetic resonance imaging data to spatially encode magnetic spins within the bore 156 of the magnet 154. The magnetic field gradient coils 160 are connected to a magnetic field gradient coil power supply 162. The magnetic field gradient coils 160 are intended to be representative. Typically, magnetic field gradient coils 160 contain three separate sets of coils for spatial encoding in three orthogonal spatial directions. The magnetic field gradient power supply 162 supplies current to the magnetic field gradient coils 160. The current supplied to the magnetic field gradient coils 160 is controlled as a function of time and may be ramped or pulsed.

Furthermore, the magnetic resonance imaging system 100 may comprise an RF transmitter coil 161 for manipulating the orientations of magnetic spins. The RF transmitter coil 161 may also be referred to as a transmitter antenna. The RF transmitter coil 161 is connected to an RF transceiver 163. It is understood that the RF transmitter coil 161 and the RF transceiver 163 are representative. The RF transmitter coil 161 may have multiple transmitter elements and the RF transceiver 163 may have multiple transmitter channels. The transceiver 163 may also represent a separate transmitter(s) and receiver(s).

The transceiver 163 and the gradient controller 162 are shown as being connected to the hardware interface 406 of the computer 400. The computational system 400 is intended to represent one or more computational or computing devices. The computational system 400 is configured for acquiring medical imaging data 414 as part of a control system of the magnetic resonance system 100. For example, the pulse sequence commands 412 may be configured to acquire the magnetic resonance imaging data 414 according to a CEST magnetic resonance imaging protocol with SPIR fat suppression, e.g., an APT-weighted magnetic resonance imaging protocol with SPIR fat suppression. For a partial inversion pulse of the SPIR a varying flip angle may be used, which is varied depending on the saturation frequencies being used. The exemplary magnetic resonance system 100 with the computational system 400 may, e.g., be configured to execute the method of Fig. 9 for acquiring the magnetic resonance imaging data 414 using pulse sequence commands 412. For this purpose, a specification of the plurality of saturation frequencies 416 and a specification of a desired residual total longitudinal magnetization 418 of fat at a time, when an excitation pulse for the magnetic resonance imaging data acquisition is applied, may be received. The desired residual total longitudinal magnetization 418 of fat is constant over the saturation frequencies of the plurality of saturation frequencies 416. The specification of the plurality of saturation frequencies 416 and the specification of the desired residual magnetization 418 may be used to determine flip angle values 420 for varying the flip angle in dependency of the saturation frequencies of the plurality of saturation frequencies 416, in order to achieve the desired residual magnetization 418.

It is understood that one or more of the aforementioned examples may be combined as long as the combined embodiments are not mutually exclusive.

As will be appreciated by one skilled in the art, aspects of the present invention may be embodied as an apparatus, method, or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer readable storage medium' as used herein encompasses any tangible storage medium which may store instructions which are executable by a processor or computational system of a computing device. The computer readable storage medium may be referred to as a computer readable non-transitory storage medium. The computer readable storage medium may also be referred to as a tangible computer readable medium. In some embodiments, a computer readable storage medium may also be able to store data which is able to be accessed by the computational system of the computing device. Examples of computer readable storage media include, but are not limited to: a floppy disk, a magnetic hard disk drive, a solid-state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer readable storage medium. Computer memory is any memory which is directly accessible to a computational system. 'Computer storage' or 'storage' is a further example of a computer readable storage medium. Computer storage is any non-volatile computer readable storage medium. In some embodiments computer storage may also be computer memory or vice versa.

A 'computational system' as used herein refers to an electronic component comprising a computational component which is able to execute a program or machine executable instruction or computer executable code. References to the computational system comprising the example of "a computational system" should be interpreted as possibly containing more than one computational component or processing core. The computational system may for instance be a multi-core processor. A computational system may also refer to a collection of computational components within a single computer system or distributed amongst multiple computer systems. The term computational system should also be interpreted to possibly refer to a collection or network of computing devices each comprising a processor or computational component. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++, or the like, and conventional procedural programming languages, such as C or similar programming languages, and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowcharts, illustrations, and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special-purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, a tactile electronic display, a Braille screen, a Cathode ray tube (CRT), a storage tube, a bi-stable display, electronic paper, a vector display, a flat panel display, a Vacuum fluorescent display (VF), a Light-emitting diode (LED) display, an Electroluminescent display (ELD), a Plasma display panel (PDP), a Liquid crystal display (LCD), an Organic light-emitting diode display (OLED), a projector, and a head-mounted display.

MRI data is defined herein as being the recorded measurements of RF signals emitted by atomic spins using the antenna of a magnetic resonance apparatus during an MRI scan. MRI data is an example of medical image data. An MR image is defined herein as being the reconstructed two- or three-dimensional visualization of anatomic data contained within the MRI data. This visualization can be performed using a computer. A Z-spectrum acquisition is magnetic resonance data that is suitable for reconstructing a Z-spectrum or image.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

| | |
|---|---|
| 100 | magnetic resonance imaging system |
| 118 | subject |
| 120 | support |
| 154 | magnet |
| 156 | bore of magnet |
| 158 | region of interest |
| 159 | imaging zone |
| 160 | magnetic field gradient coils |
| 161 | radio frequency transmitter coil |
| 162 | magnetic field gradient coil power supply |
| 163 | transceiver |
| 400 | computational system |
| 402 | computational component |
| 404 | memory |
| 406 | hardware interface |
| 408 | user interface |
| 410 | machine readable instructions |
| 412 | pulse sequence commands |
| 414 | magnetic resonance imaging data |
| 416 | plurality of saturation frequencies |
| 418 | desired residual total longitudinal magnetization |
| 420 | plurality of flip angle values |
| 450 | signal from fat |
| 452 | signal from water |

**Claims**

1. A magnetic resonance imaging system (100) configured for acquiring magnetic resonance imaging data (414) from a subject (118) within an imaging zone (159), wherein the magnetic resonance imaging system (100) comprises:
   a processor (402) configured to control the magnetic resonance imaging system (100) with pulse sequence commands (412) to acquire the magnetic resonance imaging data (414) for a plurality of saturation frequencies (416), wherein for a partial inversion pulse of the spectral presaturation with inversion recovery, SPIR, a varying flip angle is used, which is varied depending on the saturation frequencies (416) being used.

2. The magnetic resonance imaging system (100) of claim 1, wherein a chemical exchange saturation transfer, CEST, magnetic resonance imaging protocol comprises the SPIR fat suppression.

3. The magnetic resonance imaging system (100) of claim 2, wherein the CEST magnetic resonance imaging protocol is an amide proton transfer, APT, weighted magnetic resonance imaging protocol.

4. The magnetic resonance imaging system (100) of any of the previous claims, wherein the acquired magnetic resonance imaging data (414) is Z-spectrum imaging data for the plurality of saturation frequencies (416).

5. The magnetic resonance imaging system (100) of claim 4, wherein the Z-spectrum imaging data is used for a magnetization transfer ratio asymmetry analysis.

6. The magnetic resonance imaging system (100) of any of the previous claims, wherein the processor is further configured to:

    - receive a specification of a desired residual total longitudinal magnetization (418) of fat, which is constant over the saturation frequencies (416), for a time, when an excitation pulse for the magnetic resonance imaging data (414) acquisition is applied;
    - determine for the saturation frequencies (416) flip angle values (420) for varying the flip angle, wherein the flip angle values (420) depend on the saturation frequencies (416) and are determined to achieve the desired residual total longitudinal magnetization (418) of fat.

7. The magnetic resonance imaging system (100) of claim 6, wherein a relation between the flip angle values and the saturation frequencies is solved (420) numerically.

8. The magnetic resonance imaging system (100) of claim 6, wherein a relation between the flip angle values and the saturation frequencies is solved using an analytical approximation of the relation.

9. The magnetic resonance imaging system (100) of any of the claims 6 to 8, wherein the desired residual total longitudinal magnetization (418) of fat is zero.

10. The magnetic resonance imaging system (100) of any of previous claims 6 to 8, wherein the desired residual total longitudinal magnetization (418) of fat is non-zero.

11. The magnetic resonance imaging system (100) of claim 10, wherein the desired residual total longitudinal magnetization (418) of fat lies within a range from 1% to 20%, preferably 5% to 15%, and more preferably 9% to 11%.

12. A method of operating a magnetic resonance imaging system (100) for acquiring magnetic resonance imaging data (414) from a subject (118) within an imaging zone (159), comprising:

    - acquiring the magnetic resonance imaging data (414) for a plurality of saturation frequencies (416), wherein for a partial inversion pulse of the spectral presaturation with inversion recovery, SPIR, a varying flip angle is used, which is varied depending on the saturation frequencies (416) being used.

13. The method of claim 12, wherein a chemical exchange saturation transfer, CEST, magnetic resonance imaging protocol comprises the SPIR fat suppression.

14. The method of claim 12, wherein the CEST magnetic resonance imaging protocol is an amide proton transfer, APT, weighted magnetic resonance imaging protocol.

15. A computer program comprising machine executable instructions, wherein execution of the machine executable instructions causes a computational system to perform a method according to any of the claims 12 to 14.

Fig. 1

Fig. 2

Fig. 3

Fig. 4

Fig. 5

Fig. 6

Fig. 7

Fig. 8

Receiving a plurality of saturation frequencies 200

Receiving a specification of a desired residual total longitudinal magnetization 202

Determining a plurality of flip angle values for varying the SPIR flip angle with the saturation frequencies 204

Acquiring MRI data for the plurality of saturation frequencies with the SPIR flip angle being varied using the flip angle values 206

Fig. 9

406

410 412 414 416

418 420

402

408

404

400

Fig. 10

Fig. 11

Europäisches
Patentamt

European
Patent Office

Office européen
des brevets

## EUROPEAN SEARCH REPORT

**Application Number**

EP 24 15 5291

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/373100 A1 (ZHANG YI [CN] ET AL) 2 December 2021 (2021-12-02) * the whole document * | 1-15 | INV. G01R33/56 |
| A | VINOGRADOV ELENA ET AL: "CEST-MRI for body oncologic imaging: are we there yet?", NMR IN BIOMEDICINE., vol. 36, no. 6, 14 January 2023 (2023-01-14), XP093176390, GB ISSN: 0952-3480, DOI: 10.1002/nbm.4906 Retrieved from the Internet: URL:https://onlinelibrary.wiley.com/doi/full-xml/10.1002/nbm.4906> * Section "3.1 Presence of lipids in tissue" * | 1-15 | |
| A | KATHARINA TKOTZ ET AL: "Multi-echo-based fat artifact correction for CEST MRI at 7 T", MAGNETIC RESONANCE IN MEDICINE, WILEY-LISS, US, vol. 91, no. 2, 27 September 2023 (2023-09-27), pages 481-496, XP072542397, ISSN: 0740-3194, DOI: 10.1002/MRM.29863 * the whole document * | 1-15 | TECHNICAL FIELDS SEARCHED (IPC) G01R |

-/--

The present search report has been drawn up for all claims

| Place of search | Date of completion of the search | Examiner |
|---|---|---|
| Munich | 19 June 2024 | Durst, Markus |

EPO FORM 1503 03.82 (P04C01)

page 1 of 2

Europäisches
Patentamt

European
Patent Office

Office européen
des brevets

**EUROPEAN SEARCH REPORT**

**Application Number**

EP 24 15 5291

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JOCHEN KEUPP ET AL.: "Z-Spectral Water-Fat Separation for APTw MRI in the Body using efficient Single-Echo Acquisitions", PROCEEDINGS OF THE INTERNATIONAL SOCIETY FOR MAGNETIC RESONANCE IN MEDICINE, ISMRM, 27TH ANNUAL MEETING AND EXHIBITION, MONTRÉAL, QUÉBEC, CANADA, 11 MAY - 16 MAY 2019, no. 146, 26 April 2019 (2019-04-26), XP040707533, * the whole document * | 1-15 | |
| A | ZHAO YU ET AL: "Self-adapting multi-peak water-fat reconstruction for the removal of lipid artifacts in chemical exchange saturation transfer (CEST) imaging", MAGNETIC RESONANCE IN MEDICINE, vol. 82, no. 5, 26 June 2019 (2019-06-26), pages 1700-1712, XP093175900, US ISSN: 0740-3194, DOI: 10.1002/mrm.27859 Retrieved from the Internet: URL:https://onlinelibrary.wiley.com/doi/full-xml/10.1002/mrm.27859> * the whole document * | 1-15 | TECHNICAL FIELDS SEARCHED (IPC) |

The present search report has been drawn up for all claims

| Place of search | Date of completion of the search | Examiner |
|---|---|---|
| Munich | 19 June 2024 | Durst, Markus |

EPO FORM 1503 03.82 (P04C01)

## ANNEX TO THE EUROPEAN SEARCH REPORT
## ON EUROPEAN PATENT APPLICATION NO.

EP 24 15 5291

This annex lists the patent family members relating to the patent documents cited in the above-mentioned European search report.
The members are as contained in the European Patent Office EDP file on
The European Patent Office is in no way liable for these particulars which are merely given for the purpose of information.

19-06-2024

| Patent document cited in search report | Publication date | Patent family member(s) | | Publication date |
|---|---|---|---|---|
| US 2021373100 A1 | 02-12-2021 | CN | 109521383 A | 26-03-2019 |
| | | JP | 6941232 B2 | 29-09-2021 |
| | | JP | 2021503316 A | 12-02-2021 |
| | | US | 2021373100 A1 | 02-12-2021 |
| | | WO | 2020078131 A1 | 23-04-2020 |

EPO FORM P0459

For more details about this annex : see Official Journal of the European Patent Office, No. 12/82